# EUROPEAN PATENT APPLICATION

(11) **EP 4 207 595 A1**
(43) Date of publication of application: **05.07.2023**
(21) Application number: 21945830.4
(22) Date of filing: 31.12.2021
(51) Int. Cl.: H03H 3/02, H03H 9/13, H03H 9/17

(54) **PIEZOELECTRIC STRUCTURE AND MANUFACTURING METHOD THEREFOR, AND PIEZOELECTRIC RESONATOR COMPRISING PIEZOELECTRIC STRUCTURE**

(30) Priority: 16.06.2021 CN 202110666170
(71) Applicant: Suzhou HunterSun Electronics Co., Ltd., Suzhou, Jiangsu 215000 (CN)
(72) Inventor: LIU, Hairui, Su Zhou, Jiangsu 215000 (CN); LAI, Zhiguo, Su Zhou, Jiangsu 215000 (CN); TANG, Zhaoyun, Su Zhou, Jiangsu 215000 (CN); YANG, Qinghua, Su Zhou, Jiangsu 215000 (CN)
(74) Representative: IPrime Rentsch Kaelin AG
(86) International application number: PCT/CN2021/143455
(87) International publication number: WO 2022/262256

(57) **Abstract**

The present disclosure relates to a piezoelectric structure with an optimized electromechanical coupling coefficient, a method for manufacturing the piezoelectric structure, and a piezoelectric resonator including the piezoelectric structure. The piezoelectric structure according to the present disclosure may include a piezoelectric layer doped with a first doping element at a first doping concentration. The first doping concentration varies along a thickness direction of the piezoelectric layer with at least two change rates. An electromechanical coupling coefficient of the piezoelectric layer continuously varies along the thickness direction of the piezoelectric layer. According to the present disclosure, a piezoelectric structure with an electromechanical coupling coefficient varying continuously and/or cyclically along a thickness direction of a piezoelectric layer may be obtained without significant increase of extra process cost, and a figure of merit of a piezoelectric resonator including the piezoelectric structure is finally improved.

## Description

### FIELD

The present disclosure relates to the technical field of microelectronic devices and electronic devices, and in particular to a piezoelectric structure, a method for manufacturing the piezoelectric structure, and a piezoelectric resonator including the piezoelectric structure.

### BACKGROUND

Piezoelectric materials (ceramics, thin films, and crystals) have excellent capabilities of electromechanical conversion, and therefore are widely used in various fields, especially in the field of microelectronic devices and electronic devices. Mechanical resonance characteristics inherent to such piezoelectric materials help to realize conversion between acoustic signals (sound waves) and electrical signals. Since an acoustic wave travels much faster than an electromagnetic wave, an acoustic filter based on the piezoelectric theory has a much smaller geometric dimension than an LTCC filter or a LC oscillation filter, and has become a mainstream solution for a radio frequency front-end filter, duplexer, multiplexer, and other chips in wireless communication.

A figure of merit (FOM) of a piezoelectric resonator made from a piezoelectric material is determined by an electromechanical coupling coefficient kₜ² and a quality factor Q, that is, FOM=kₜ^{2∗}Q. The electromechanical coupling coefficient characterizes an ability of the piezoelectric structure for coupling and conversion between an acoustic energy and an electric energy, and is directly proportional to a bandwidth of a working frequency. The quality factor characterizes an edge energy loss level of an effective resonant region. A greater FOM of the piezoelectric resonator indicates a less passband insertion loss and a greater out-of-band rejection of a filter constructed by the piezoelectric resonator, which means a better performance. However, decrease of the insertion loss is usually contradictory to increase of the out-of-band rejection, that is, a high electromechanical coupling coefficient and a high quality factor are usually not achievable simultaneously for the piezoelectric resonator. How to achieve a good trade-off between the electromechanical coupling coefficient and the quality factor for a piezoelectric resonator is still one of the important technical problems to be solved urgently in the technical field.

### SUMMARY

Hereinafter provides a brief summary of the present disclosure, in order to provide a basic understanding of certain aspects of the present disclosure. It should be understood, however, that this summary is not an exhaustive overview of the present disclosure, nor is it intended to identify key or critical parts of the present disclosure, nor is it intended to limit the scope of the present disclosure. The summary is only intended to present some inventive concepts related to the present disclosure in a simplified form as a prelude to the more detailed description that is presented later.

An objective of the present disclosure is to provide a piezoelectric structure with an optimized electromechanical coupling coefficient and an optimized quality factor, and a method for manufacturing the piezoelectric structure.

According to an aspect of the present disclosure, a piezoelectric structure is provided. The piezoelectric structure includes a piezoelectric layer doped with a first doping element at a first doping concentration. The first doping concentration varies along a thickness direction of the piezoelectric layer with at least two change rates. An electromechanical coupling coefficient of the piezoelectric layer varies along the thickness direction of the piezoelectric layer.

According to an embodiment of the present disclosure, the electromechanical coupling coefficient of the piezoelectric layer may be minimum at an upper surface and/or a lower surface of the piezoelectric layer.

According to an embodiment of the present disclosure, the piezoelectric layer may include a material of a wurtzite structure or perovskite structure.

According to an embodiment of the present disclosure, the piezoelectric layer may include an inorganic or organic piezoelectric material that is monocrystalline or polycrystalline.

According to an embodiment of the present disclosure, the first doping element may include at least one of Ti, Sc, Mg, Zr, Hf, Sb, Y, Sm, Eu, Er, Ta and Cr.

According to an embodiment of the present disclosure, the piezoelectric layer may be further doped with a second doping element at a second doping concentration.

According to an embodiment of the present disclosure, the second doping concentration may vary along the thickness direction of the piezoelectric layer with at least two change rates.

According to an embodiment of the present disclosure, the second doping element may include at least one of B, Ga and In.

According to an embodiment of the present disclosure, the at least two change rates of the first doping concentration includes a first change rate and a second change rate. The first change rate causes the electromechanical coupling coefficient of the piezoelectric layer to increase from the upper surface of the piezoelectric layer toward the lower surface of the piezoelectric layer. The second change rate causes the electromechanical coupling coefficient of the piezoelectric layer to increase from the lower surface of the piezoelectric layer toward the upper surface of the piezoelectric layer.

According to an embodiment of the present disclosure, an absolute value of the first change rate and an absolute value of the second change rate may vary along the thickness direction of the piezoelectric layer.

According to an embodiment of the present disclosure, the first doping concentration may vary cyclically along the thickness direction of the piezoelectric layer.

According to an embodiment of the present disclosure, the first doping concentration may have a same value at a starting point and an end point of one cycle.

According to an embodiment of the present disclosure, the first doping concentration may have different values at a starting point and an end point of one cycle.

According to an embodiment of the present disclosure, the first doping concentration may be 0% at both a starting point and an end point of one cycle.

According to another aspect of the present disclosure, a piezoelectric resonator including the piezoelectric structure according to the above aspects of the present disclosure is provided.

According to a further aspect of the present disclosure, a filter including the piezoelectric resonator according to the above aspects of the present disclosure is provided. According to an embodiment of the present disclosure, the filter may be a bulk acoustic wave filter, a surface acoustic wave filter, a Lamb wave filter, or other acoustic filter.

According to a further aspect of the present disclosure, a duplexer or multiplexer including the filter according to the above aspects of the present disclosure is provided.

According to a further aspect of the present disclosure, a method for manufacturing a piezoelectric structure is provided. The method includes: preparing, through a sputtering process, a piezoelectric layer doped with a first doping element at a first doping concentration. The first doping concentration varies along a thickness direction of the piezoelectric layer with at least two change rates. An electromechanical coupling coefficient of the piezoelectric layer varies along the thickness direction of the piezoelectric layer.

With the piezoelectric structure and the method for manufacturing the same according to the embodiments of the present disclosure, a piezoelectric resonator with an optimized electromechanical coupling coefficient and an optimized figure of merit can be manufactured through a conventional semiconductor processing, so as to improve the figure of merit of the piezoelectric resonator. In addition, with the piezoelectric layer according to the embodiments of the present disclosure, a miniaturized piezoelectric semiconductor device supporting high frequency band and large bandwidth communication can be realized.

### BRIEF DESCRIPTION OF THE DRAWINGS

Accompanying drawings are included to provide a further understanding of the present disclosure, and are incorporated in and constitute a part of this specification. The drawings are intended to illustrate embodiments of the present disclosure and, together with the following description, to explain principles of the present disclosure.
Figure 1A to Figure 1C illustrate cross-sectional views of a harmonic oscillator and a piezoelectric resonator including a piezoelectric structure according to an embodiment of the present disclosure.
Figure 2A and Figure 2B are diagrams illustrating distribution of a first doping concentration and an electromechanical coupling coefficient that vary along a thickness direction of a piezoelectric layer according to a first embodiment of the present disclosure.
Figure 3A to Figure 3E are diagrams illustrating distribution of an electromechanical coupling coefficient, a first doping concentration, and a second doping concentration that vary along a thickness direction of a piezoelectric layer according to a second embodiment of the present disclosure.
Figure 4 is a diagram illustrating distributing of an electromechanical coupling coefficient along a thickness direction of a piezoelectric layer according to a third embodiment of the present disclosure.

### DETAILED DESCRIPTION

In this specification, it is to be understood that when an element is referred to as being "on", "connected to" or "coupled to" another element, the element may be directly disposed on, directly connected or directly coupled to the another element, or there may be a third element between the element and the another element. In contrast, when an element is referred to as being "directly on", "directly connected to", or "directly coupled to" another element, there is no element between the element and the another element.

The present disclosure is described more comprehensively hereinafter with reference to the accompanying drawings, in which various embodiments are illustrated. However, the present disclosure may be embodied in many different forms and should not be construed as limited to the embodiments set forth herein. The embodiments are provided so that the present disclosure is thorough and complete, and fully convey the scope of the disclosure to those skilled in the art. Through the specification, same reference signs refer to same elements throughout. The thicknesses, ratios and dimensions of components are exaggerated in the drawings, for clarity of explanation.

The terminology used herein is for the purpose of describing particular embodiments only and is not intended to be limiting. Unless clearly dictated in the context otherwise, expressions such as "a," "an," "the," and "at least one of" used herein do not indicate a limit to quantity, but are intended to cover both the singular and the plural. For example, unless clearly dictated in the context otherwise, "an element" is synonymous with "at least one element", "at least one" should not be construed as being limited to a quantity of "one", and "or" refers to "and/or". The term "and/or" covers any and all combinations of one or more of the associated listed items.

It should be understood that although terms such as "first" and "second" are used herein to define stated objects, these objects should not be limited by these terms. These terms are used only to distinguish one object from another. For example, an object referred to as a first object, such as a first doping element, in an embodiment may be referred to as a second object, such as a second doping element, in other embodiments, without departing from the scope of the appended claims.

In addition, terms such as "lower", "below", "upper", "above", and the like, are used to describe positional relationships of components shown in the drawings. Such terms may indicate relative concepts and are described based on directions presented in the drawings.

In consideration of measurements in question and errors associated with the measurements of particular quantities, words "about" or "approximately" are used herein to cover both a stated value and an average value within an acceptable deviation range with respect to a particular value as determined by those of ordinary skill in the art. For example, "about" may refer to an average within one or more standard deviations, or an average within ±30%, ±20%, ±10%, ±5% of a stated value.

Unless otherwise defined, all terms used herein, including technical and scientific terms, have the same meaning as commonly understood by one of ordinary skill in the art. Terms as defined in commonly used dictionaries should be construed as having the same meaning as in the relevant technical context; and unless explicitly defined in the specification, such terms are not to be interpreted in an idealized or overly formal sense to have a formal meaning.

Words such as "comprising" or "including" specifies a nature, quantity, step, operation, element, component or a combination thereof, but does not exclude other natures, quantities, steps, operations, elements, components or combinations thereof.

Embodiments are described herein with reference to schematic cross-sectional views according to preferred embodiments. Thereby, variations of shape from the illustrations are contemplated, as a result of, for example, manufacturing techniques and/or tolerances. Therefore, the embodiments described herein should not be construed as limited to the specific shapes of regions as illustrated herein, but are to include deviations from shapes due to, for example, manufacturing. For example, regions shown or described as flat may typically be rough and/or nonlinear. Besides, an acute angle shown can be rounded. Thus, the regions illustrated in the figures are schematic in nature and shapes thereof are not intended to illustrate precise shapes of the regions and are not intended to limit the scope of the claims.

Hereinafter, exemplary embodiments of the present disclosure are described with reference to the accompanying drawings.

In order to solve the above problems, a piezoelectric structure according to an embodiment of the present disclosure may include a piezoelectric layer doped with a first doping element at a first doping concentration. The first doping concentration varies along a thickness direction of the piezoelectric layer with at least two change rates, and an electromechanical coupling coefficient of the piezoelectric layer continuously varies along the thickness direction of the piezoelectric layer.

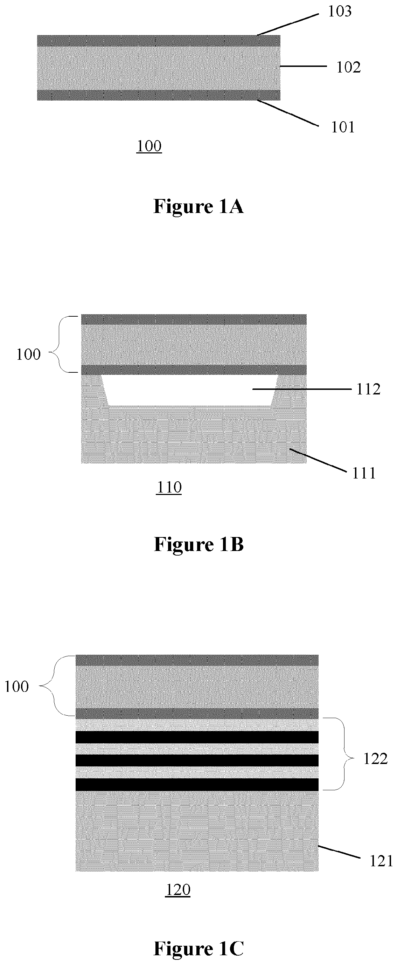

Figure 1A to Figure 1C illustrate cross-sectional views of a harmonic oscillator and a piezoelectric resonator including a piezoelectric structure according to an embodiment of the present disclosure. Figure 1A shows a harmonic oscillator 100 including a piezoelectric structure according to an embodiment of the present disclosure. The harmonic oscillator 100 includes a lower electrode 101, a piezoelectric structure including a piezoelectric layer 102, and an upper electrode 103, which are stacked in the listed sequence.

Reference is made further to Figure 1B and Figure 1C. The harmonic oscillator 100 may be connected to a cavity serving as a reflection element or a Bragg reflection layer, to form a cavity-type piezoelectric resonator 110 or a solidly mounted piezoelectric resonator 120. As shown in Figure 1B, the cavity-type piezoelectric resonator 110 may include a substrate 111, a cavity 112, and the harmonic oscillator 100 as shown in Figure 1A, which are disposed from bottom to top in the above-listed sequence. As shown in Figure 1C, the solidly mounted piezoelectric resonator 120 may include a substrate 121, a Bragg reflection layer 122, and the harmonic oscillator 100 as shown in Figure 1A, which are disposed from bottom to top in the above-listed sequence. An inside part or edge of the piezoelectric resonator may be of one or more of the following structures: a frame structure, a protruding structure, a recess structure, an air wing, an air bridge, and the like.

Those skilled in the art should appreciate that although the embodiments of the present disclosure are described herein by taking a cavity-type piezoelectric resonator and a solidly mounted piezoelectric resonator as examples, the present disclosure is not limited thereto. The piezoelectric structure according to the present disclosure is also applicable to other types of piezoelectric resonators.

According to an embodiment of the present disclosure, each of the substrate 111 and the substrate 121 may be a silicon (Si) substrate, a silicon carbide (SiC) substrate, a gallium arsenide (GaAs) substrate, or a flexible substrate.

In addition, according to an embodiment of the present disclosure, the lower electrode 101 and the upper electrode 103 are configured to apply excitation to the piezoelectric layer 102, and may be formed by a metallic conductive material selected from molybdenum (Mo), tungsten (W), aluminum (Al), a platinum/Titanium (Pt/Ti) stack, or a gold/chromium (Au/Cr) stack.

According to an embodiment of the present disclosure, an electromechanical coupling coefficient of the piezoelectric layer 102 may vary along a thickness direction of the piezoelectric layer, which is described in detail below. Variation of the electromechanical coupling coefficient may be realized by doping with one, two or more doping elements. In a preferred embodiment, only one doping element is doped in an interval where the electromechanical coupling coefficient changes monotonically.

According to an embodiment of the present disclosure, a basis material of the piezoelectric layer 102 may be an inorganic or organic piezoelectric material that is monocrystalline or polycrystalline. The material of the piezoelectric layer 102 includes but is not limited to: a wurtzite structure, such as aluminum nitride (AlN) or zinc oxide (ZnO); a perovskite structure, such as BaTiO₃, Pb(Ti,Zr)O₃, Li(Nb,Ta)O₃, or (K,Na)NbO₃; and organic piezoelectric materials, such as polyvinylidene fluoride PVDF.

According to an embodiment of the present disclosure, in order to improve the Figure of Merit FOM of the piezoelectric structure, the piezoelectric layer 102 may be doped with a first doping element to regulate the electromechanical coupling coefficient of the piezoelectric layer 102. The first doping element may increase the electromechanical coupling coefficient of the piezoelectric layer 102, and may include, but is not limited to: Ti, Sc, Mg, Zr, Hf, Sb, Y, Sm, Eu, Er, Ta, and Cr.

In addition, according to an embodiment of the present disclosure, the first doping concentration of the first doping element may vary along the thickness direction of the piezoelectric layer at a first change rate and a second change rate, where the second change rate is different from the first change rate. According to an embodiment of the present disclosure, doping the piezoelectric layer at the first doping concentration having at least two change rates causes the electromechanical coupling coefficient of the piezoelectric layer to vary along the thickness direction of the piezoelectric layer, thereby regulating the electromechanical coupling coefficient of the piezoelectric layer. According to a preferred embodiment of the present disclosure, the first doping concentration of the first doping element causes the electromechanical coupling coefficient to have the minimum value at an upper surface and/or a lower surface of the piezoelectric layer, so as to reduce edge energy leakage.

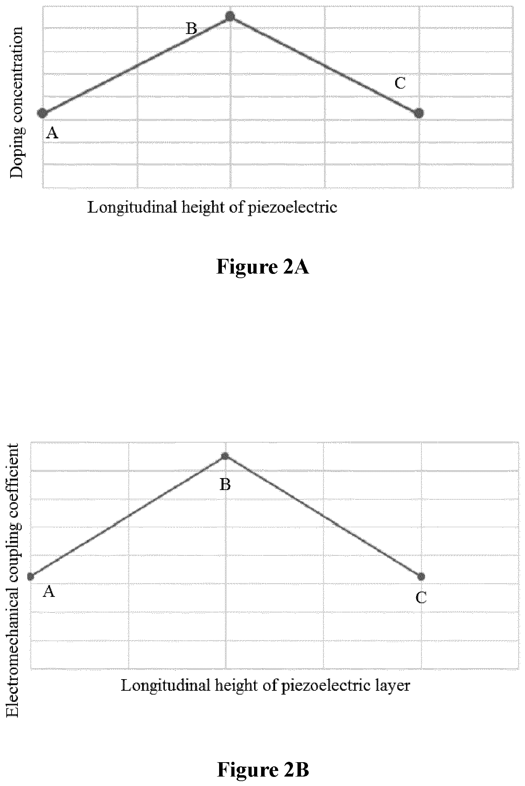

Figure 2A and Figure 2B are diagrams illustrating distribution of a first doping concentration and an electromechanical coupling coefficient that vary along a thickness direction of a piezoelectric layer according to a first embodiment of the present disclosure.

In Figure 2A, an abscissa represents a longitudinal height of the piezoelectric layer, and an ordinate represents the first doping concentration of the first doping element. A minimum value of the first doping concentration of the first doping element may be 0%, or may be greater than 0% and less than 50%. A maximum value of the first doping concentration of the first doping element is greater than the minimum value of the first doping concentration and less than 50%.

As shown in Figure 2A, the first doping concentration of the first doping element may separately vary at a first change rate and a second change rate along a thickness direction of the piezoelectric layer. According to an embodiment of the present disclosure, the first change rate may cause the electromechanical coupling coefficient of the piezoelectric layer to increase from a lower surface of the piezoelectric layer toward an upper surface of the piezoelectric layer, and the second change rate may cause the electromechanical coupling coefficient of the piezoelectric layer to increase from the upper surface of the piezoelectric layer toward the lower surface of the piezoelectric layer. In other words, as shown in Figure 2A, the electromechanical coupling coefficient of the piezoelectric layer increases, due to the first change rate, from point A at the lower surface of the piezoelectric layer toward point B at a position of the piezoelectric layer away from both the upper electrode and the lower electrode; and the electromechanical coupling coefficient of the piezoelectric layer decreases, due to the second change rate, from the point B at the position of the piezoelectric layer away from both the upper electrode and the lower electrode toward point C at the upper surface of the piezoelectric layer. According to an embodiment of the present disclosure, variation of the first doping concentration may be linear, as shown in Figure 2A, or may be non-linear. For example, along the thickness direction of the piezoelectric layer, some intervals of the piezoelectric layer are doped with the first doping element, while some intervals of the piezoelectric layer are not doped with the first doping element.

According to an embodiment of the present disclosure, the first doping concentration at the point A may be the same as or different from the first doping concentration at the point C.

In a preferred embodiment of the present disclosure, an absolute value of the first change rate may be equal to an absolute value of the second change rate. In a preferred embodiment, the first doping concentration at the upper surface of the piezoelectric layer may be the same as the first doping concentration at the lower surface of the piezoelectric layer. In a further preferred embodiment of the present disclosure, the first change rate and the second change rate may take certain values such that the first doping concentration at the upper surface of the piezoelectric layer and the first doping concentration at the lower surface of the piezoelectric layer are both 0%.

In Figure 2B, an abscissa represents a longitudinal height of the piezoelectric layer, and an ordinate represents the electromechanical coupling coefficient. As shown in Figure 2B, the electromechanical coupling coefficient of the piezoelectric layer is minimum at the upper surface of the piezoelectric layer and the lower surface of the piezoelectric layer, so as to reduce edge energy leakage, such that the electromechanical coupling coefficient of the piezoelectric layer at a position away from both the upper electrode and the lower electrode is maximum relative to the electromechanical coupling coefficient at the upper surface and the lower surface of the piezoelectric layer. A minimum value of the electromechanical coupling coefficient may range from 5% to 20%, and the maximum value of the electromechanical coupling coefficient may range from the minimum value to 20%.

According to the first embodiment of the present disclosure, a continuous regulation of the electromechanical coupling coefficient in the piezoelectric layer may be achieved by adjusting distribution of the first doping concentration of the first doping element along the thickness direction of the piezoelectric layer, so as to avoid problems in the piezoelectric layer including lattice mismatch and decrease in a degree of c-axis orientation due to doping of the first doping element.

Furthermore, according to the first embodiment of the present disclosure, the first doping concentration of the first doping element along the thickness direction of the piezoelectric layer is regulated to be maximum at the position away from both the upper electrode and the lower electrode and minimum at surfaces in contact with the upper electrode and the lower electrode, such that increase of mechanical loss due to doping is suppressed.

In addition, although doping the piezoelectric layer with the first doping element for increasing the electromechanical coupling coefficient effectively improves the electromechanical coupling coefficient of the piezoelectric layer and expands the bandwidth, a sound speed is reduced and mechanical loss is increased due to the doping, reducing the quality factor of the piezoelectric resonator, and making it difficult to achieve effective out-of-band suppression. Therefore, according to an embodiment of the present disclosure, the piezoelectric layer may be further doped with a second doping element for improving the quality factor, in combination with the first doping element. According to an embodiment of the present disclosure, the second doping element may include at least one of B, Ga, and In. According to a preferred embodiment of the present disclosure, B may be used as the second doping element.

In an embodiment, the electromechanical coupling coefficient of the piezoelectric layer is proportional to the first doping concentration of the first doping element and the second doping concentration of the second doping element, in a case that the first doping concentration of Sc as the first doping element, for example, ranges from 0% to 30% and the second doping concentration of B as the second doping element, for example, ranges from 0% to 20%. The first doping concentration of the first doping element and the second doping concentration of the second doping element may be regulated by controlling a process parameter, such as a sputtering power, so as to regulate the electromechanical coupling coefficient of the piezoelectric layer. A gradient variation of the doping concentration of the doping element and a continuous variation of the electromechanical coupling coefficient may be realized through settings of the process parameter.

Doping of the second doping element improves the quality factor of the piezoelectric layer, but may decrease the electromechanical coupling coefficient. Therefore, according to an embodiment of the present disclosure, a combined adjustment of the first doping concentration of the first doping element and the second doping concentration of the second doping element may be performed to optimize the electromechanical coupling coefficient and quality factor, realizing an optimization of the figure of merit. That is, by adjusting the first doping concentration of the first doping element and the second doping concentration of the second doping element, the electromechanical coupling coefficient may be improved while ensuring a high quality factor.

In this regard, the electromechanical coupling coefficient of the piezoelectric layer is related to the first doping concentration of the first doping element and the second doping concentration of the second doping element. An increase of the first doping concentration of the first doping element may result in an increase of the electromechanical coupling coefficient, while an increase of the second doping concentration of the second doping element may result in a decrease of the electromechanical coupling coefficient. Therefore, a ratio of the two doping concentrations may be adjusted so that the final electromechanical coupling coefficient of the piezoelectric layer has the distribution that first increases and then decreases along the thickness direction of the piezoelectric layer as shown in Figure 2B, such that the electromechanical coupling coefficient is optimized while ensuring the quality factor.

For example, the electromechanical coupling coefficient is minimum at the lower surface of the piezoelectric layer, where the first doping concentration of the first doping element is minimum (e.g., 0) and the second doping concentration of the second doping element is maximum. With increase of the longitudinal height of the piezoelectric layer, the first doping concentration of the first doping element is increased, and the second doping concentration of the second doping element is decreased, such that the first doping concentration of the first doping element is maximum and the second doping concentration of the second doping element is minimum (e.g., 0) at the position of the piezoelectric layer away from both the upper electrode and the lower electrode, and the electromechanical coupling coefficient of the piezoelectric layer is maximum at the position away from both the upper electrode and the lower electrode. Further, the first doping concentration of the first doping element and the second doping concentration of the second doping element are adjusted toward an opposite trend from the above-mentioned, so that the electromechanical coupling coefficient at the lower surface of the piezoelectric layer is minimum. In this way, the electromechanical coupling coefficient is optimized.

In addition, according to another embodiment of the present disclosure, the first doping concentration of the first doping element may vary along the thickness direction of the piezoelectric layer at the first change rate, the second change rate, a third rate change rate, and a fourth change rate different from the third change rate. The absolute value of the first change rate is different from an absolute value of the third change rate. That is, the first doping concentration of the first doping element may vary at multiple rates in a monotonically increasing interval of the electromechanical coupling coefficient from the lower surface of the piezoelectric layer to the position of the piezoelectric layer away from both the upper electrode and the lower electrode. Similarly, in a monotonically decreasing interval of the electromechanical coupling coefficient from the position of the piezoelectric layer away from both the upper electrode and the lower electrode to the upper surface of the piezoelectric layer, the first doping concentration of the first doping element may vary at multiple rates corresponding to the multiple rates in the monotonically increasing interval.

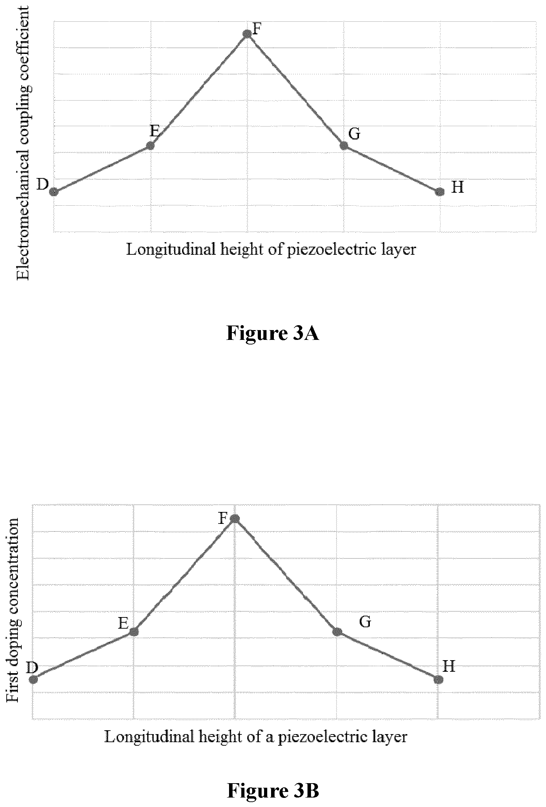

Figure 3A to Figure 3E are diagrams illustrating distributions of an electromechanical coupling coefficient, a first doping concentration, and a second doping concentration along a thickness direction of a piezoelectric layer, according to a second embodiment of the present disclosure.

In Figure 3A, an abscissa represents a longitudinal height of the piezoelectric layer, and an ordinate represents the electromechanical coupling coefficient. In addition, in Figure 3B to Figure 3E, an abscissa represents a longitudinal height of the piezoelectric layer, and an ordinate represents a doping concentration of a doping element.

As shown in Figure 3A and Figure 3B, in an increasing interval of the electromechanical coupling coefficient from point D at the lower surface of the piezoelectric layer to point F at the position of the piezoelectric layer away from both the upper electrode and the lower electrode, the first doping concentration of the first doping element may vary at the first change rate from the point D to point E, and then vary at the third change rate from the point E to the point F, so that the electromechanical coupling coefficient reaches a maximum value at the point F. Next, in a decreasing interval of the electromechanical coupling coefficient from the point F at the position of the piezoelectric layer away from both the upper electrode and the lower electrode to point H at the upper surface of the piezoelectric layer, the first doping concentration of the first doping element may vary at the fourth change rate from the point F to point G, and then vary at the second change rate from the point G to the point H.

According to a preferred embodiment of the present disclosure, an absolute value of the first change rate is equal to an absolute value of the second change rate, and an absolute value of the third change rate is equal to an absolute value of the fourth change rate. Along the thickness direction of the piezoelectric layer, a distance from the point D to the point E may be the same as or different from a distance from the point H to the point G, and a distance from the point E to the point F may be the same as or different from a distance from the point G to the point F. Preferably, the first doping concentration of the first doping element may be the same at the point D and the point H, and may be the same at the point E and the point F.

In addition, according to an embodiment of the present disclosure, along the thickness direction of the piezoelectric layer, a distance from the point D to the point E, a distance from the point E to the point F, a distance from the point F to the point G, and a distance from the point G to the point H may be the same.

Those skilled in the art should appreciate that although in the second embodiment of the present disclosure, the piezoelectric layer is doped with the first doping element at the first doping concentration varying at two change rates respectively in the increasing interval and the decreasing interval of the electromechanical coupling coefficient of the piezoelectric layer along the thickness direction of the piezoelectric layer, the present disclosure is not limited thereto. The piezoelectric layer may be doped with the first doping element at the first doping concentration varying at one or more change rates in the increasing interval and one or more change rates in the decreasing interval of the electromechanical coupling coefficient, with the change rates in the increasing interval corresponding or not corresponding to the one or more change rates in the decreasing interval, as long as the electromechanical coupling coefficient is minimum at the upper surface and the lower surface of the piezoelectric layer and is maximum at the position away from both the upper electrode and the lower electrode. All variations shall fall within the scope of this disclosure.

Those skilled in the art should further understand that although only the first doping concentration of the first doping element is described above, the piezoelectric layer may be further doped with the second doping element in order to realize an optimal trade-off between the electromechanical coupling coefficient and the quality factor, similar to what described in the first embodiment. In the second embodiment, the second doping concentration of the second doping element may, as described in the first embodiment, vary at one or more change rates in coordination with the first doping concentration of the first doping element. All variations shall fall within the scope of this disclosure.

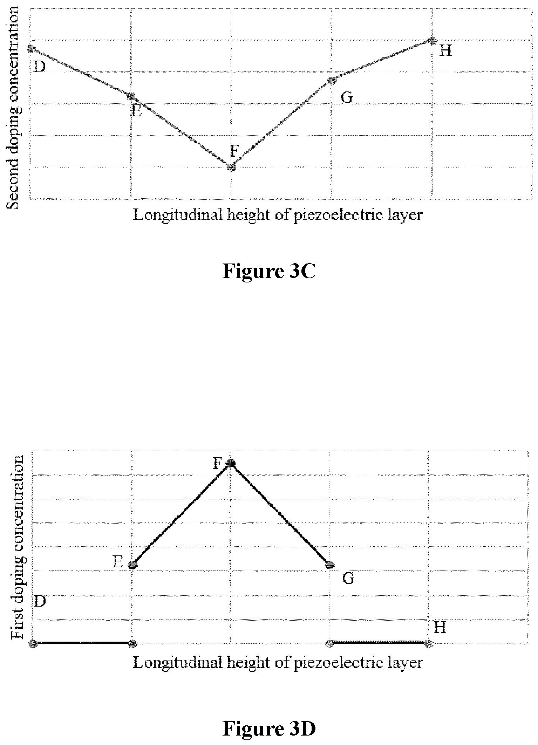

For example, as shown in Figure 3C, in an increasing interval of the electromechanical coupling coefficient from point D at the lower surface of the piezoelectric layer to point F at the position of the piezoelectric layer away from both the upper electrode and the lower electrode, the second doping concentration of the second doping element may vary at a fifth change rate from the point D to point E, and then vary at a seventh change rate from the point E to the point F, so that the electromechanical coupling coefficient reaches the maximum value at the point F. Next, in a decreasing interval of the electromechanical coupling coefficient from the point F at the position of the piezoelectric layer away from both the upper electrode and the lower electrode to point H at the upper surface of the piezoelectric layer, the second doping concentration of the second doping element may vary at an eighth change rate from the point F to point G, and then vary at a sixth change rate from the point G to the point H.

According to a preferred embodiment of the present disclosure, an absolute value of the fifth change rate is equal to an absolute value of the sixth change rate, and an absolute value of the seventh change rate is equal to an absolute value of the eighth change rate. Along the thickness direction of the piezoelectric layer, a distance from the point D to the point E may be the same as or different from a distance from the point H to the point G, and a distance from the point E to the point F may be the same as or different from a distance from the point G to the point F. Preferably, the second doping concentration of the second doping element may be the same at the point D and the point H, and may be the same at the point E and the point F.

As shown in Figure 3A to Figure 3C, the electromechanical coupling coefficient of the piezoelectric layer is minimum at the upper surface and the lower surface of the piezoelectric layer, so that lateral energy leakage is reduced. That is, the electromechanical coupling coefficient of the piezoelectric layer at the position away from both the upper electrode and the lower electrode is maximum with respect to the electromechanical coupling coefficient at the upper and lower surfaces the piezoelectric layer. Additionally, since doping of the second doping element is conducive to improving the quality factor, the quality factor of the piezoelectric layer is guaranteed.

According to a further embodiment of the present disclosure, in order to realize that the electromechanical coupling coefficient of the piezoelectric layer has multiple variation intervals as shown in Figure 3A, the piezoelectric layer may be doped with only the first doping element in certain variation intervals, and may be doped with only the second doping element in certain variation intervals.

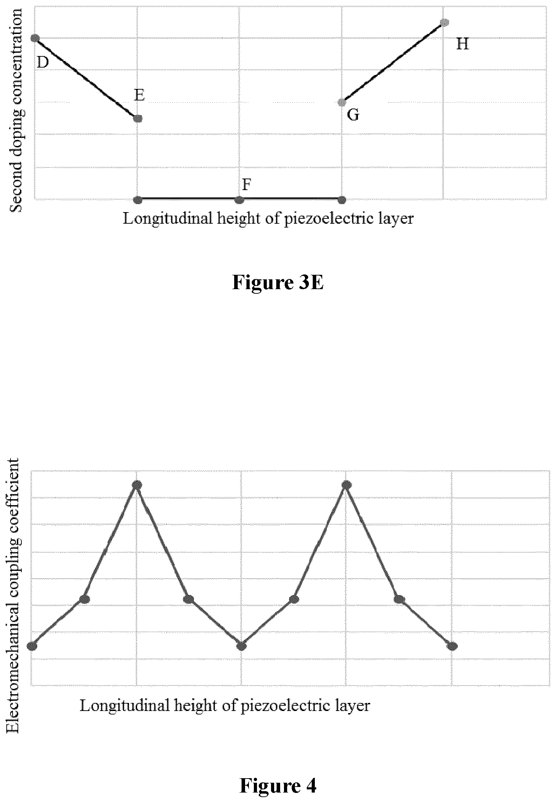

As shown in Figure 3A, the electromechanical coupling coefficient of the piezoelectric layer doped with two elements has four variation intervals. Variation of the doping concentration of the first doping element with the longitudinal height of the piezoelectric layer is as shown in Figure 3D. Variation of the doping concentration of the second doping element with the longitudinal height of the piezoelectric layer is as shown in Figure 3E. The piezoelectric layer may be doped with only the second doping element in a first interval (point D to point E in Figure 3A, Figure 3D and Figure 3E) and a fourth interval (point G to point H in Figure 3A, Figure 3D and Figure 3E) where the electromechanical coupling coefficient is minimum. As shown in Figure 3D, in the interval from the point D to the point E and the interval from the point G to the point H, the first doping concentration of the first doping element is 0%. Furthermore, as shown in Figure 3E, the second doping concentration of the second doping element may monotonically decrease from the point D toward the point E and monotonically increase from the point G toward the point H. Correspondingly, the piezoelectric layer may be doped with only the first doping element in a second interval (the point E to point F in Figure 3A, Figure 3D and Figure 3E) and a third interval (the point F to the point G in Figure 3A, Figure 3D and Figure 3E) where the electromechanical coupling coefficient is greater. In this case, as shown in Figure 3D, the first doping concentration of the first doping element may monotonically increase from the point E toward the point F and decrease monotonically from the point F toward the point G, along the thickness direction of the piezoelectric layer. In addition, as shown in Figure 3E, the second doping concentration of the second doping element may be 0%, that is, the second doping element does not exist, in the interval from the point E to the point F and the interval from the point F to the point G.

Optionally, the first doping concentration of the first doping element at the point E and/or the point G of Figure 3D may be 0%. Optionally, the second doping concentration of the second doping element at the point E and/or the point G of Figure 3E may be 0%.

With settings of the first doping concentration of the first doping element and the second doping concentration of the second doping element as shown in Figure 3D and Figure 3E, the electromechanical coupling coefficient of the piezoelectric layer is minimum at the upper surface and the lower surface of the piezoelectric layer, so that lateral energy leakage is reduced. That is, the electromechanical coupling coefficient of the piezoelectric layer at the position away from both the upper electrode and the lower electrode has the maximum value relative to the electromechanical coupling coefficient at the upper and lower surfaces of the piezoelectric layer. In addition, as doping of the second doping element is conducive to improving the quality factor, the quality factor of the piezoelectric layer may be guaranteed.

Furthermore, according to a third embodiment of the present disclosure, the first doping element and/or the second doping element causes the electromechanical coupling coefficient to vary cyclically along the thickness direction of the piezoelectric layer. A thickness of the piezoelectric layer is n times a period of the first doping concentration, where n is a natural number greater than 1.

Figure 4 is a diagram illustrating distribution of an electromechanical coupling coefficient along a thickness direction of a piezoelectric layer according to the third embodiment of the present disclosure. In Figure 4, an abscissa represents a longitudinal height of the piezoelectric layer, and an ordinate represents the electromechanical coupling coefficient.

In an example, the electromechanical coupling coefficient of the piezoelectric layer varying in two cycles is shown in Figure 4. In each of the cycles, the electromechanical coupling coefficient has a monotonically increasing interval and a monotonically decreasing interval. The variation of the electromechanical coupling coefficient may be realized by changing the first doping concentration of the first doping element, by changing the second doping concentration of the second doping element, or by changing the first doping concentration of the first doping element and the second doping concentration of the second doping element.

According to an embodiment of the present disclosure, the electromechanical coupling coefficient of the piezoelectric resonator after doping may have different values at a start point of a cycle and an end point of the cycle.

Those skilled in the art should further understand that, although in the third embodiment, the change rate of a doping concentration of a doping element is of identical distributions among the cycles, the present disclosure is not limited thereto. The doping concentration of the doping element may be of different distributions among the cycles, as long as the electromechanical coupling coefficient is minimum at the start point and the end point of each cycle and maximum at the position away from both the upper electrode and the lower electrode within the cycle. All variations shall fall within the scope of the present disclosure.

The resonator 100 as shown in Figure 1A may serve as a core unit of an RF-MEMS device, such as a thin-film bulk acoustic wave filter, a solidly mounted bulk acoustic wave filter, a secondary coupling bulk acoustic wave filter, and a Lamb wave type bulk acoustic wave filter, a multiplexer, and a duplexer. However, those skilled in the art should understand that the piezoelectric layer 102 according to the embodiments of the present disclosure is also applicable to other devices, including but not limited to transducers, sensors, actuators, energy storage devices, and the like.

A method for manufacturing a piezoelectric layer is further provided according to an embodiment of the present disclosure. The method includes preparing, through a sputtering process, a piezoelectric layer doped with a first doping element at a first doping concentration. The first doping concentration varies with at least two change rates along a thickness direction of the piezoelectric layer, and the first doping concentration results in a continuous variation of an electromechanical coupling coefficient of the piezoelectric layer along a thickness direction of the piezoelectric layer.

According to an embodiment of the present disclosure, during a process of depositing the piezoelectric layer through sputtering, a doping concentration of a doping element may be controlled by adjusting a process parameter such as a sputtering power and a sputtering time, so as to optimize the electromechanical coupling coefficient. That is, the electromechanical coupling coefficient obtained after doping the piezoelectric layer with the doping element may be proportional to the process parameter such as the sputtering power and the sputtering time. By controlling the process parameter, a distribution of the variation of the doping concentration may be realized, and an optimized distribution of the electromechanical coupling coefficient may be obtained. In this regard, a gradient variation of the doping concentration of the doping element and a continuous variation of the electromechanical coupling coefficient can be realized through settings of the sputtering power.

With the piezoelectric structure, the piezoelectric resonator, and the method for manufacturing the piezoelectric structure and the piezoelectric resonator according to the embodiments of the present disclosure, the distribution of the doping concentration of the first doping element and/or the doping concentration of the second doping element along the thickness direction of the piezoelectric layer is adjusted, so that a piezoelectric structure with an optimized electromechanical coupling coefficient and an optimized quality factor can be manufactured through a conventional semiconductor processing, thereby improving the figure of merit of the piezoelectric resonator including the piezoelectric structure. In addition, with the piezoelectric structure according to the embodiments of the present disclosure, a miniaturized piezoelectric semiconductor device supporting high frequency band and large bandwidth communication can be realized.

Although the present disclosure has been described with reference to the exemplary embodiments, those skilled in the art should appreciate that various modifications and changes can be made without departing from the spirit and scope of the present disclosure as set forth in the claims.

In addition, the present disclosure includes, but is not limited to, the following solutions:
Solution 1. A piezoelectric structure, including:
   a piezoelectric layer doped with a first doping element for increasing an electromechanical coupling coefficient at a first doping concentration, wherein
   the first doping concentration varies along a thickness direction of the piezoelectric layer, and subjects to at least one interval in which the first doping concentration monotonically increases at a first change rate and at least one interval in which the first doping concentration monotonically decreases at a second change rate, and
   the first doping concentration is greater than or equal to 0%.
Solution 2. A piezoelectric structure, comprising:
   a piezoelectric layer doped with a first doping element for increasing an electromechanical coupling coefficient at a first doping concentration, wherein
      the first doping concentration varies along a thickness direction of the piezoelectric layer, and subjects to at least one interval in which the first doping concentration monotonically increases at a first change rate and at least one interval in which the first doping concentration monotonically decreases at a second change rate, and
   a piezoelectric layer doped with a second doping element for increasing a quality factor at a second doping concentration, wherein
      the second doping concentration varies along the thickness direction of the piezoelectric layer, and subjects to at least one interval in which the second doping concentration monotonically decreases at a third change rate and at least one interval in which the second doping concentration monotonically increases at a fourth change rate, and wherein
   each of the first doping concentration and the second doping concentration is greater than or equal to 0%.
Solution 3. A piezoelectric structure, comprising:
   a co-doped piezoelectric layer doped with a first doping element for increasing an electromechanical coupling coefficient at a first doping concentration and a second doping element for increasing a quality factor at a second doping concentration, wherein
   the first doping concentration varies along a thickness direction of the piezoelectric layer, and subjects to at least one interval in which the first doping concentration monotonically increases at a first change rate and at least one interval in which the first doping concentration monotonically decreases at a second change rate,
   the second doping concentration varies along the thickness direction of the piezoelectric layer, and subjects to at least one interval in which the second doping concentration monotonically decreases at a third change rate and at least one interval in which the second doping concentration monotonically increases at a fourth change rate, and
   each of the first doping concentration and the second doping concentration is greater than or equal to 0%.
Solution 4. The piezoelectric structure according to any one of solutions 1 to 3, wherein
   the electromechanical coupling coefficient of the piezoelectric layer varies along the thickness direction continuously and/or cyclically, and
   the electromechanical coupling coefficient is minimum at an upper surface and/or a lower surface of the piezoelectric layer.
Solution 5. The piezoelectric structure according to any one of solutions 1 to 3, wherein
   the first doping element comprises at least one of Ti, Sc, Mg, Zr, Hf, Sb, Y, Sm, Eu, Er, Ta and Cr.
Solution 6. The piezoelectric structure according to any one of solutions 2 to 3, wherein
   the second doping element comprises at least one of B, Ga and In.
Solution 7. The piezoelectric structure according to any one of solutions 1 to 3, wherein
   the piezoelectric layer comprises a material of a wurtzite structure or perovskite structure.
Solution 8. The piezoelectric structure according to any one of solutions 1 to 3, wherein
   the piezoelectric layer comprises an inorganic or organic piezoelectric material that is monocrystalline or polycrystalline.
Solution 9. The piezoelectric structure according to any one of solutions 1 to 3, wherein
   the first change rate, the second change rate, the third change rate, and the fourth change rate are constant, and are natural numbers.
Solution 10. The piezoelectric structure according to any one of solutions 1 to 3, wherein
   the first change rate, the second change rate, the third change rate, and the fourth change rate vary along the thickness direction of the piezoelectric layer.
Solution 11. A piezoelectric resonator, comprising the piezoelectric structure according to any one of solutions 1 to 12.
Solution 12. A bulk or surface acoustic wave filter, comprising the piezoelectric resonator according to solution 11.
Solution 13. A duplexer or multiplexer, comprising the filter according to solution 12.
Solution 14. A method for manufacturing a piezoelectric structure comprising a piezoelectric layer, comprising:
   preparing a piezoelectric layer under different doping conditions through regulation of a sputtering process, wherein
   the piezoelectric layer is doped to have an electromechanical coupling coefficient that continuously varies along a thickness direction of the piezoelectric layer, and
   the electromechanical coupling coefficient is minimum at an upper surface and/or lower surface of the piezoelectric layer.

## Claims

1. A piezoelectric structure, comprising:
a piezoelectric layer doped with a first doping element for increasing an electromechanical coupling coefficient at a first doping concentration, wherein
the first doping concentration varies along a thickness direction of the piezoelectric layer, and subjects to at least one interval in which the first doping concentration monotonically increases at a first change rate and at least one interval in which the first doping concentration monotonically decreases at a second change rate, and
the first doping concentration is greater than or equal to 0%.

2. A piezoelectric structure, comprising:
a piezoelectric layer doped with a first doping element for increasing an electromechanical coupling coefficient at a first doping concentration, wherein
the first doping concentration varies along a thickness direction of the piezoelectric layer, and subjects to at least one interval in which the first doping concentration monotonically increases at a first change rate and at least one interval in which the first doping concentration monotonically decreases at a second change rate, and
a piezoelectric layer doped with a second doping element for increasing a quality factor at a second doping concentration, wherein
the second doping concentration varies along the thickness direction of the piezoelectric layer, and subjects to at least one interval in which the second doping concentration monotonically decreases at a third change rate and at least one interval in which the second doping concentration monotonically increases at a fourth change rate, and wherein
each of the first doping concentration and the second doping concentration is greater than or equal to 0%.

3. A piezoelectric structure, comprising:
a co-doped piezoelectric layer doped with a first doping element for increasing an electromechanical coupling coefficient at a first doping concentration and a second doping element for increasing a quality factor at a second doping concentration, wherein
the first doping concentration varies along a thickness direction of the piezoelectric layer, and subjects to at least one interval in which the first doping concentration monotonically increases at a first change rate and at least one interval in which the first doping concentration monotonically decreases at a second change rate,
the second doping concentration varies along the thickness direction of the piezoelectric layer, and subjects to at least one interval in which the second doping concentration monotonically decreases at a third change rate and at least one interval in which the second doping concentration monotonically increases at a fourth change rate, and
each of the first doping concentration and the second doping concentration is greater than or equal to 0%.

4. The piezoelectric structure according to any one of claims 1 to 3, wherein
the electromechanical coupling coefficient of the piezoelectric layer varies along the thickness direction continuously and/or cyclically, and
the electromechanical coupling coefficient is minimum at an upper surface and/or a lower surface of the piezoelectric layer.

5. The piezoelectric structure according to any one of claims 1 to 3, wherein
the first doping element comprises at least one of Ti, Sc, Mg, Zr, Hf, Sb, Y, Sm, Eu, Er, Ta and Cr.

6. The piezoelectric structure according to any one of claims 2 to 3, wherein
the second doping element comprises at least one of B, Ga and In.

7. The piezoelectric structure according to any one of claims 1 to 3, wherein
the piezoelectric layer comprises a material of a wurtzite structure or perovskite structure.

8. The piezoelectric structure according to any one of claims 1 to 3, wherein
the piezoelectric layer comprises an inorganic or organic piezoelectric material that is monocrystalline or polycrystalline.

9. The piezoelectric structure according to any one of claims 1 to 3, wherein
the first change rate, the second change rate, the third change rate, and the fourth change rate are constant, and are natural numbers.

10. The piezoelectric structure according to any one of claims 1 to 3, wherein
the first change rate, the second change rate, the third change rate, and the fourth change rate vary along the thickness direction of the piezoelectric layer.

11. A piezoelectric resonator, comprising the piezoelectric structure according to any one of claims 1 to 12.

12. A bulk or surface acoustic wave filter, comprising the piezoelectric resonator according to claim 11.

13. A duplexer or multiplexer, comprising the filter according to claim 12.

14. A method for manufacturing a piezoelectric structure comprising a piezoelectric layer, comprising:
preparing a piezoelectric layer under different doping conditions through regulation of a sputtering process, wherein
the piezoelectric layer is doped to have an electromechanical coupling coefficient that continuously varies along a thickness direction of the piezoelectric layer, and
the electromechanical coupling coefficient is minimum at an upper surface and/or lower surface of the piezoelectric layer.
